# EUROPÄISCHE PATENTSCHRIFT

(11) **EP 0 534 066 B1**
(45) Veröffentlichungstag und Bekanntmachung des Hinweises auf die Patenterteilung: **30.08.1995**
(21) Anmeldenummer: 92110914.6
(22) Anmeldetag: 27.06.1992
(51) Int. Cl.: C23C 14/32, C23C 14/02, H01J 37/32

(54) **Lichtbogen-Beschichtungsanlage mit zusätzlicher Ionisationsanode**
Arc discharge coating apparatus with auxiliary ionization anode
Appareil pour revêtement par décharge d'arc avec anode auxiliaire d'ionisation

(30) Priorität: 31.07.1991 DE 4125365
(43) Veröffentlichungstag der Anmeldung: 31.03.1993
(73) Patentinhaber: METAPLAS Oberflächenveredelungstechnik GmbH, D-51427 Bergisch Gladbach (DE)
(72) Erfinder: Vetter, Jörg, D-5060 Bergisch Gladbach 2 (DE); Schmidt-Mauer, Manfred, D-5063 Overath (DE); Matentzoglu Nikolaus, D-5204 Lohmar 21 (DE)
(74) Vertreter: Stenger, Watzke & Ring Patentanwälte

(56) Entgegenhaltungen:
- EP-A- 0 309 733
- DE-A- 3 829 260
- US-A- 3 793 179
- US-A- 4 620 913
- PATENT ABSTRACTS OF JAPAN, vol. 12, no. 198 (C-502)(3045), 8. Juni 1988; & JP-A-63 000 458

## Beschreibung

Die vorliegende Erfindung betrifft eine Lichtbogen-Beschichtungsanlage mit
a) einer evakuierbaren, gegebenenfalls kontrolliert mit einem Reaktions- oder Inertgas füllbaren, die zu beschichtenden Teile enthaltenden Kammer;
b) in der Kammer elektrisch isoliert von dieser angeordneten, durch den Lichtbogen verzehrbaren Kathoden, die an eine erste Gleichstromquelle angeschlossen sind;
c) eine zweite, auf einer höheren Spannung als die erste befindliche Gleichstromquelle, an deren negativen Pol die elektrisch isoliert von der Kammer angeordneten, zu beschichtenden Teile angeschlossen sind wobei
d) die positiven Pole der ersten und zweiten Gleichstromquellen an mindestens eine erste Anode angeschlossen sind.

Lichtbogen-Beschichtungsanlagen der beschriebenen Art sind im Grundsatz aus der US-A-3 793 179 bekannt. Über Weiterentwicklungen hat die Anmelderin in der VDI-Zeitschrift 129 (1987) Nr. 1, Seiten 89 bis 94 berichtet.

Um eine gute Haftfestigkeit der mittels des Lichtbogen-Beschichtungsverfahrens aufgebrachten Schichten (meist aus Zirkonnitrid) zu gewährleisten, wird vor dem eigentlichen Beschichtungsprozeß und nach außerhalb der Anlage durchgeführten, chemischen Reinigungsverfahren eine besonders intensive Reinigung der zur Beschichtung vorgesehenen Objekte (der sog. "Substrate") vorgenommen, indem die Substrate einem Bombardement mit Ionen ausgesetzt werden, die aus dem durch die Lichtbogenentladung hergestellten Plasma stammen. Dieses Ionenbombardement dient auch dazu, die Substrate auf eine für den Beschichtungsprozeß geeignete Temperatur zu erhitzen. Als nachteilig hat sich hierbei herausgestellt, daß insbesondere bei der Bearbeitung von Teilen mit ungleichmäßiger Massenverteilung und Geometrie es zu Überhitzungen oder Ätzungen einzelner Teile der Substrate kommen kann. Auch läßt sich nicht ganz vermeiden, daß auf der Oberfläche der Substrate (trotz der an sie angelegten hohen negativen Vorspannungen von bis zu 1000 V) Zwischenschichten einigermaßen undefinierter Zusammensetzung gebildet werden. Ferner besteht nach wie vor das Bestreben, den Einbau makroskopischer, nicht in den Plasmazustand überführter Teilchen des durch die Lichtbogenentladung verzehrten Materials (der sog. "Droplets") in die Schicht zu vermeiden, da deren Aussehen und Rauhigkeit hierdurch ungünstig beeinflußt werden.

Aufgabe der Erfindung ist eine Lichtbogen-Beschichtungsanlage der beschriebenen Art, in der die Ionenreinigung und Erwärmung der Substrate nicht direkt durch die Ionen des Plasmastrahles erfolgt, sondern durch eine Glimmentladung, die zu einem erhöhten Ionisationsgrad der in dieser Verfahrensphase verwendeten Gase führt.

Die Lösung dieser Aufgabe erfolgt dadurch, daß eine zweite, von der ersten elektrisch isoliert angeordnete Anode vorhanden ist, die an eine dritte Gleichstromquelle angeschlossen ist, die sich auf einer höheren Spannung als die erste Gleichstromquelle befindet. Durch ihr positives Potential gegenüber dem Plasma wird aus diesem ein Teil der Plasmaelektronen abgesaugt und auf Energien beschleunigt, die der Potentialdifferenz zwischen dem Plasma und der zweiten Anode entsprechen. Je nach dem Ionisationsquerschnitt der verwendeten Gase führt dies zu einer Erhöhung des Ionisationsgrades in der Beschichtungskammer. Die Reinigung der Substrate und deren Erwärmung erfolgt nunmehr durch das Auftreffen der Gasionen auf dieselben, wobei die Bildung schädlicher Zwischenschichten ausgeschlossen wird.

In weiterer Ausgestaltung der Erfindung besteht die zweite Anode aus einem magnetischen Werkstoff. Hierdurch wird eine erhöhte Wirkung auf die Elektronen ausgeübt.

In weiterer Ausgestaltung der Erfindung ist die Wand der Beschichtungskammer als erste Anode geschaltet. Dies vereinfacht die Konstruktion.

Eine weitere Vereinfachung der Konstruktion wird durch ein zusätzliches Merkmal der Erfindung erreicht, indem die dritte Gleichstromquelle mit ihrem negativen Pol an die Kammer angeschlossen ist.

Lichtbogen-Beschichtungsanlagen der beschriebenen Art werden meistens, insbesondere wenn sie größere Abmessungen aufweisen, mit mehreren Kathoden (zugleich oder nacheinander) betrieben. In weiterer Ausgestaltung der Erfindung ist die zweite Anode in gleichem Abstand zu jeder der Kathoden angeordnet.

In weiterer Ausgestaltung der Erfindung weist die zweite Anode die Gestalt eines zumindest einseitig offenen, mit der offenen Seite auf die zu beschichtenden Teile gerichteten, über einen Steg an der Kammer befestigten Bügel auf. Diese Form hat sich als besonders günstig herausgestellt, um die gewünschte Beschleunigung der Elektronen aus dem Plasma zu erzielen.

Um die zu beschichtenden Teile davor zu bewahren, mit kleinen Teilchen des Kathodenmaterials, die nicht in den Plasmazustand überführt wurden, verunreinigt zu werden, sind entsprechend einer weiteren Ausgestaltung der Erfindung zumindest für einen Teil der Kathoden zwischen zwei Endlagen hin- und herbewegliche Schirme vorhanden, die in ihrer einen Endlage die direkte Sicht von der jeweiligen Kathode auf die zu beschichtenden Teile versperren und in ihrer anderen Endlage vollständig freigeben. Die erste der genannten Alternativen wird in den vorbereitenden Stadien des Prozesses, nämlich zur Ionenreinigung und zur Erwärmung der Substrate angewendet (wobei die Stromdichte der aus dem Plasmastrahl bei an die Substrate angelegter negativer Spannung extrahierten Ionen sehr stark abnimmt); die zweite Alternative demgegenüber wird während des eigentlichen Beschichtungsprozesses realisiert.

In weiterer Ausgestaltung der Erfindung ist eine durch einen ersten Schalter unterbrechbare elektrische Verbindung zwischen der dritten Gleichstromquelle und den zu beschichtenden Teilen vorhanden sowie ein die elektrische Verbindung zwischen der ersten Gleichstromquelle und den zu beschichtenden Teilen unterbrechender zweiter Schalter; ferner ein dritter Schalter, mit dem die elektrische Verbindung zwischen der dritten Gleichstromquelle und der zweiten Anode unterbrochen werden kann.

Eine derart ausgerüstete Lichtbogen-Beschichtungsanlage kann erfindungsgemäß auf vier verschiedene Arten betrieben werden: erstens zur Ionenreinigung der zu beschichtenden Teile, indem der erste Schalter geöffnet und der zweite und dritte Schalter geschlossen sind und die Schirme in ihrer die Sicht versperrenden (geschlossenen) Endlage; zweitens zur Aufheizung der zu beschichtenden Teile, indem der erste Schalter geschlossen und der zweite und dritte Schalter geöffnet sind, und die Schirme in der vorigen Lage verbleiben; drittens zur zusätzlichen Aufheizung der zweiten Anode, indem der erste und dritte Schalter geschlossen und der zweite Schalter geöffnet sind bei gleicher Endlage der Schirme; und viertens zur Beschichtung, indem der erste und dritte Schalter geöffnet und der zweite Schalter geschlossen sind, wobei die Schirme in ihre die Sicht freigebende (offene) Endlage geschwenkt werden.

Die Erfindung betrifft weiterhin ein Verfahren zum Betrieb einer Lichtbogen-Beschichtungsanlage nach der Erfindung, das dadurch gekennzeichnet ist, daß der erste Schalter geöffnet und der zweite und dritte Schalter geschlossen sowie die Schirme in ihrer die Sicht versperrenden Endlage sind. Gemäß weiteren Ausgestaltungen der Erfindung kann entweder zum Zwecke der Ionenreinigung der zu beschichtenden Teile ein Inertgas oder zum Zwecke des Beschichtens mit einer Kohlenstoffschicht zusätzlich ein kohlenstoffhaltiges Gas in die Kammer eingelassen werden. Falls die Lichtbogen-Beschichtungsanlage der Erfindung zum Zwecke des Aufheizens der zu beschichtenden Teile betrieben werden soll, sind gemäß einer weiteren Ausgestaltung der erste Schalter geschlossen und der zweite und dritte Schalter geöffnet sowie die Schirme in ihrer die Sicht versperrenden Endlage.

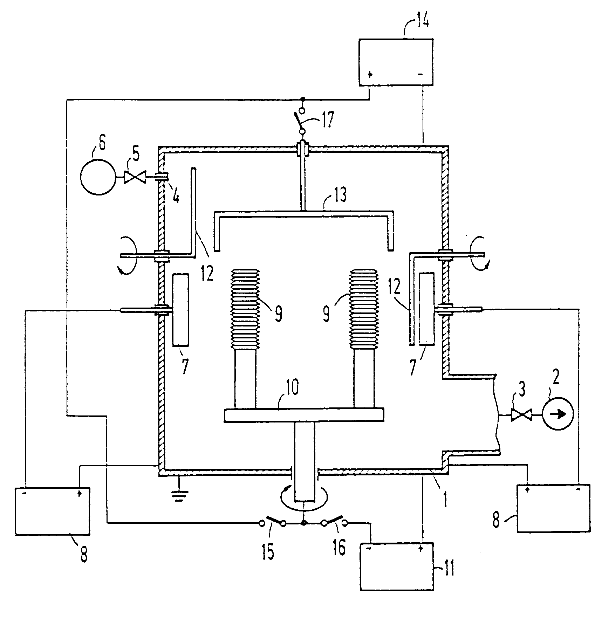

Ein Ausführungsbeispiel der Erfindung ist schematisch in der Zeichnung dargestellt. Eine Lichtbogen-Beschichtungsanlage besteht zunächst aus einer Kammer 1, die mit Hilfe einer Pumpe 2, die über ein erstes Ventil 3 zuschaltbar ist, evakuiert werden kann. Anschließend kann über eine Einlaßleitung 4, die durch ein zweites Ventil 5 absperrbar ist, aus Speichern 6 (hier nur einer dargestellt) eines der verschiedenen im Prozeß verwendeten, z. Beispiel auch kohlenstoffhaltigen Gase eingefüllt werden; dicht in die Wand der Kammer 1 eingelassen sind Verdampfer 7, die in Bezug auf erste Gleichstromquellen 8 als Kathode geschaltet sind und aus einem oder mehreren der zu verdampfenden und in die Beschichtung eingehenden Metalle, z. B. Titan, bestehen. Wird mittels hier nicht gezeigter Mittel zwischen den Verdampfern 7 und der als Anode geschalteten Wand der Kammer 1 eine Lichtbogenentladung gezündet, wird dieses Material verdampft und zum größten Teil in den Plasmazustand überführt; es kann dann mit dem die Kammer füllenden Prozeßgas, z. B. Stickstoff oder Azetylen, zu z. B. Titannitrid oder Titankarbid reagieren, das sich auf den zu beschichtenden Gegenständen 9, z. B. Werkzeugen für die spanende Formgebung niederschlägt. Diese Gegenstände sind auf Haltevorrichtungen 10 angebracht, die mittels einer hier nicht gezeigten Einrichtung in Drehung versetzt werden können, um eine allseits gleichmäßige Beschichtung zu erzielen.

Die Teile 9 sind dabei mittels eines zweiten Schalters 16 als Kathode einer zweiten Gleichstromquelle 11 schaltbar; während die ersten Gleichstromquellen bevorzugt bei einer Spannung bis zu 40 V und Strömen bis zu 300 A betrieben werden, liefert die zweite Gleichstromquelle 11 Spannungen bis zu 1500 V und Ströme bis zu 20 A. Hierdurch wird erreicht, daß sich der durch Reaktion in der Plasmaphase gebildete Beschichtungsstoff bevorzugt auf den Teilen 9 und nur zu einem geringeren Teil an unerwünschten Stellen, z. B. der Wand der Kammer 1, niederschlägt.

Vor der Einleitung der eigentlichen Beschichtungsphase ist jedoch ein Aufheizen der Teile 9 auf Prozeßtemperatur (etwa 200 bis 500° C) erforderlich sowie eine Reinigung der Oberfläche der Teile 9, z. B. von Oxidhäuten, die sich an der Luft gebildet haben. Bei der an sich möglichen Durchführung dieses Bearbeitungsschrittes mittels eines direkten Bombardements der Teile 9 mit den Ionen aus dem Plasma, das sich durch die Lichtbogenentladung gebildet hat, empfiehlt es sich stattdessen, die Teile 9 vor der direkten Wirkung der Verdampfer 7 abzuschirmen, indem in die Sichtlinie der beiden Teile drehbar angeordnete Schirme 12 eingeschwenkt werden (in der rechten Hälfte der Zeichnung dargestellt, während in der linken Hälfte die Stellung eines Schirms 12 während der eigentlichen Beschichtung dargestellt ist). Zusätzlich ist eine zweite, bügelförmige Anode 13 vorgesehen, die in etwa gleichem Abstand zu den verschiedenen Verdampfern 7 angeordnet und mittels eines dritten Schalters 17 als Anode an eine dritte Gleichstromquelle 14 geschaltet werden kann; diese liefert Spannungen von bis zu 100 V bei Strömen bis zu 300 A. Die dritte Gleichstromquelle 14 ist über einen ersten Schalter 15 auch mit den zu beschichtenden Teilen 9 verbindbar. Diese zweite Anode 13 verstärkt den Ionisationsgrad in der Kammer 1 und beschleunigt die Ionen des Plasmas in Richtung auf die Teile 9, die auf diese Weise einer schonenden Reinigung und Erwärmung unterzogen werden. Dadurch, daß sowohl die Kammer 1 als auch die jeweils freien Pole der verschiedenen Gleichstromquellen 8, 11, 14 an Erde gelegt sind, sind sie elektrisch zu einem Gesamtsystem verbunden, bei dem lediglich die dritte Gleichstromquelle 14 mit ihrer Kathode an Erde, die übrigen Gleichstromquellen dagegen mit ihrer Anode an Erde gelegt sind.

Für die verschiedenen Prozeßphasen ergeben sich die folgenden Schalter- und Schirmstellungen:

| | Schalter 15 | Schalter 16 | Schalter 17 | Schirme |
|---|---|---|---|---|
| 1. Ionenreinigung der Teil 9 | offen | geschlossen | geschlossen | geschlossen |
| 2. Aufheizen der Teile 9 | geschlossen | offen | offen | geschlossen |
| 3. Zusätzlich Aufheizen der Anode 13 | geschlossen | offen | geschlossen | geschlossen |
| 4. Beschichtung der Teil 9 | offen | geschlossen | offen | offen bis geschlossen |

## Patentansprüche

1. Lichtbogen-Beschichtungsanlage mit
a) einer evakuierbaren, gegebenenfalls kontrolliert mit einem Reaktions- oder Inertgas füllbaren, die zu beschichtenden Teile (9) enthaltenden Kammer (1),
b) in der Kammer (1) elektrisch isoliert von dieser angeordneten, durch den Lichtbogen verzehrbaren Kathoden (7), die an erste Gleichstromquellen (8) angeschlossen sind,
c) eine zweite auf einer höheren Spannung als die erste befindliche Gleichstromquelle (11), an deren negativem Pol die elektrisch isoliert von der Kammer (1) angeordneten, zu beschichtenden Teile (9) angeschlossen sind, wobei
d) die positiven Pole der ersten und zweiten Gleichstromquellen mindestens an eine erste Anode angeschlossen sind, **dadurch gekennzeichnet**, daß
e) eine zweite, von der ersten elektrisch isoliert angeordnete Anode (13) vorhanden ist, die an eine dritte Gleichstromquelle (14) angeschlossen ist, die sich auf einer höheren Spannung als die erste Gleichstromquelle befindet.

2. Lichtbogen-Beschichtungsanlage nach Anspruch 1, **dadurch gekennzeichnet,** daß die zweite Anode (13) aus einem magnetischen Werkstoff besteht.

3. Lichtbogen-Beschichtungsanlage nach Anspruch 1 oder 2, **dadurch gekennzeichnet**, daß die Wand der Kammer (1) als erste Anode geschaltet ist.

4. Lichtbogen-Beschichtungsanlage nach Anspruch 1, 2 oder 3, **dadurch gekennzeichnet**, daß die dritte Gleichstromquelle (14) mit ihrem negativen Pol an die Kammer (1) angeschlossen ist.

5. Lichtbogen-Beschichtungsanlage nach Anspruch 1, 2, 3 oder 4 mit mehreren Kathoden 7, **dadurch gekennzeichnet**, daß die zweite Anode (13) in gleichem Abstand zu jeder der Kathoden angeordnet ist.

6. Lichtbogen-Beschichtungsanlage nach Anspruch 5, **dadurch gekennzeichnet,** daß die zweite Anode (13) die Gestalt eines zumindest einseitig offenen, mit der offenen Seite auf die zu beschichtenden Teile (9) gerichteten, über einen Steg an der Kammer (1) befestigten Bügels hat.

7. Lichtbogen-Beschichtungsanlage nach einem oder mehreren der vorhergehenden Ansprüche, **dadurch gekennzeichnet**, daß zumindest für einen Teil der Kathoden (7) zwischen zwei Endlagen hin und her bewegliche Schirme (12) vorhanden sind, die in ihrer einen Endlage die direkte Sicht von der jeweiligen Kathode (7) auf die zu beschichtenden Teile (9) versperren und in ihrer anderen Endlage vollständig freigeben.

8. Lichtbogen-Beschichtungsanlage nach einem oder mehreren der vorhergehenden Ansprüche, **dadurch gekennzeichnet**, daß
a) eine durch einen ersten Schalter (15) unterbrechbare elektrische Verbindung zwischen der dritten Gleichstromquelle (14) und den zu beschichtenden Teilen (9) vorhanden ist,
b) die elektrische Verbindung zwischen der ersten Gleichstromquelle (11) und den zu beschichtenden Teilen (9) durch einen zweiten Schalter (16) unterbrechbar ist,
c) die elektrische Verbindung zwischen der dritten Gleichstromquelle (14) und der zweiten Anode (13) durch einen dritten Schalter (17) unterbrechbar ist.

9. Verfahren zum Betrieb einer Lichtbogen-Beschichtungsanlage nach Anspruch 7 und 8, **dadurch gekennzeichnet**, daß der erste Schalter (15) geöffnet und der zweite und dritte Schalter (16,17) geschlossen sowie die Schirme (12) in ihrer die Sicht versperrenden Endlage sind.

10. Verfahren nach Anspruch 9, **dadurch gekennzeichnet**, daß zum Zwecke der Ionenreinigung der zu beschichtenden Teile (9) ein Inertgas in die Kammer (1) eingelassen wird.

11. Verfahren nach Anspruch 10, **dadurch gekennzeichnet**, daß zum Zwecke des Beschichtens der Teile (9) mit einer Kohlenstoffschicht zusätzlich ein kohlenstoffhaltiges Gas in die Kammer (1) eingelassen wird.

12. Verfahren zum Betrieb einer Lichtbogen-Beschichtungsanlage nach Anspruch 7 und 8, **dadurch gekennzeichnet**, daß zum Zwecke des Aufheizens der zu beschichtenden Teile (9) der erste Schalter (15) geschlossen und der zweite und dritte Schalter (16,17) geöffnet sowie die Schirme (12) in ihrer die Sicht versperrenden Endlage sind.

## Claims

1. Electric arc coating apparatus having
a) an evacuatable chamber (1) which contains the parts (9) to be coated and is capable, as the case may be, of being filled in a controlled fashion with a reaction gas or inert gas,
b) cathodes (7) which are arranged in the chamber (1) electrically insulated therefrom, can be consumed by the electric arc and are connected to first DC sources (8), and
c) a second DC source (11), which is at a higher voltage than the first and to whose negative terminal the parts (9) to be coated, which are arranged in a fashion electrically insulated from the chamber (1), are connected,
d) the positive terminals of the first and second DC sources being connected at least to a first anode, characterized in that
e) a second anode (13), arranged in a fashion electrically insulated from the first, is connected to a third DC source (14) which is at a higher voltage than the first DC source.

2. Electric arc coating apparatus according to Claim 1, characterized in that the second anode (13) consists of a magnetic material.

3. Electric arc coating apparatus according to Claim 1 or 2, characterized in that the wall of the chamber (1) is connected as first anode.

4. Electric arc coating apparatus according to Claim 1, 2 or 3, characterized in that the third DC source (14) is connected with its negative terminal to the chamber (1).

5. Electric arc coating apparatus according to Claim 1, 2, 3 or 4 and having a plurality of cathodes 7, characterized in that the second anode (13) is arranged at the same distance from each of the cathodes.

6. Electric arc coating apparatus according to Claim 5, characterized in that the second anode (13) has the shape of a U-bolt which is open at least at one end, has the open end directed towards the parts (9) to be coated and is fastened to the chamber (1) via a web.

7. Electric arc coating apparatus according to one or more of the preceding claims, characterized in that screens (12) which can be moved to and fro between two end positions and which in their one end position block the direct view from the respective cathode (7) to the parts (9) to be coated and completely uncover said view in their other end position are present for at least some of the cathodes (7).

8. Electric arc coating apparatus according to one or more of the preceding claims, characterized in that
a) an electrical connection which can be interrupted by a first switch (15) is present between the third DC source (14) and the parts (9) to be coated,
b) the electrical connection between the first DC source (11) and the parts (9) to be coated can be interrupted by a second switch (16), and
c) the electrical connection between the third DC source (14) and the second anode (13) can be interrupted by a third switch (17).

9. Method for operating an electric arc coating apparatus according to Claims 7 and 8, characterized in that the first switch (15) is open and the second and third switches (16, 17) are closed and the screens (12) are in their end position blocking the view.

10. Method according to Claim 9, characterized in that an inert gas is introduced into the chamber (1) for the purpose of ionic cleaning of the parts (9) to be coated.

11. Method according to Claim 10, characterized in that a carbon-containing gas is introduced in addition into the chamber (1) for the purpose of coating the parts (9) with a carbon layer.

12. Method for operating an electric arc coating apparatus according to Claims 7 and 8, characterized in that for the purpose of heating the parts (9) to be coated the first switch (15) is closed and the second and third switches (16, 17) are open and the screens (12) are in their end position blocking the view.

## Revendications

1. Installation de revêtement par décharge d'arc électrique, comprenant:
a) une chambre (1) dans laquelle peut être réalisé le vide, pouvant, le cas échéant être remplie de manière contrôlée, par un gaz de réaction ou un gaz inerte, et renfermant les pièces (9) devant être revêtues;
b) des cathodes (7) disposées dans la chambre (1) en étant électriquement isolées de celle-ci, qui sont consommables sous l'effet de l'arc électrique, et qui sont raccordées à des premières sources de courant continu (8);
c) une seconde source de courant continu (11) se trouvant à une tension plus élevée que la première, et au pôle négatif de laquelle sont raccordées les pièces (9) devant être revêtues et disposées de manière à être électriquement isolées de la chambre (1),
d) les pôles positifs des premières et de la seconde sources de courant continu étant raccordés à au moins une première anode,
caractérisée en ce qu'est prévue une seconde anode (13) disposée de manière à être électriquement isolée de la première, et raccordée à une troisième source de courant continu (14) se trouvant à une tension supérieure à celle de la première source de courant continu.

2. Installation de revêtement par décharge d'arc électrique selon la revendication 1, caractérisée en ce que la seconde anode (13) est réalisée en un matériau magnétique.

3. Installation de revêtement par décharge d'arc électrique selon la revendication 1 ou 2, caractérisée en ce que la paroi de la chambre (1) est mise en circuit en tant que première anode.

4. Installation de revêtement par décharge d'arc électrique selon la revendication 1, 2 ou 3, caractérisée en ce que la troisième source de courant continu (14) est raccordée, avec son pôle négatif, à la chambre (1).

5. Installation de revêtement par décharge d'arc électrique selon la revendication 1, 2, 3 ou 4, caractérisée en ce que la seconde anode (13) est disposée de manière à être équidistante de chacune des cathodes.

6. Installation de revêtement par décharge d'arc électrique selon la revendication 5, caractérisée en ce que la seconde anode (13) présente une configuration d'un étrier ouvert sur au moins un côté, le côté ouvert étant dirigé vers les pièces (9) devant être revêtues, et fixé à la chambre (1) par l'intermédiaire d'une nervure.

7. Installation de revêtement par décharge d'arc électrique selon l'une ou plusieurs des revendications précédentes, caractérisée en ce que pour au moins une partie des cathodes (7), sont prévus des masques (12), qui peuvent être déplacés selon un mouvement alternatif entre deux positions extrêmes, et qui dans une de leurs positions extrêmes, entravent le champ de visée directe de la cathode (7) considérée vers les pièces (9) devant être revêtues, et le libère totalement dans l'autre position extrême.

8. Installation de revêtement par décharge d'arc électrique selon l'une ou plusieurs des revendications précédentes, caractérisée
a) en ce qu'est prévue une liaison électrique entre la troisième source de courant continu (14) et les pièces (9) devant être revêtues, cette liaison pouvant être interrompue par un premier interrupteur (15),
b) en ce que la liaison électrique entre la première source de courant continu (11) et les pièces (9) devant être revêtues, peut être interrompue par un second interrupteur (16), et
c) en ce que la liaison électrique entre la troisième source de courant continu (14) et la seconde anode (13) peut être interrompue par un interrupteur (17).

9. Procédé destiné à faire fonctionner l'installation de revêtement par décharge d'arc électrique selon les revendications 7 et 8, caractérisé en ce que le premier interrupteur (15) est ouvert, le second et le troisième interrupteurs (16, 17) sont fermés, et les masques (12) sont dans leur position extrême entravant le champ de visée.

10. Procédé selon la revendication 9, caractérisé en ce qu'un gaz inerte est admis dans la chambre (1), dans le but d'un nettoyage ionique des pièces (9) devant être revêtues.

11. Procédé selon la revendication 10, caractérisé en ce que pour un revêtement des pièces (9) par une couche de carbone, un gaz à teneur en carbone est admis en supplément, dans la chambre (1).

12. Procédé destiné à faire fonctionner une installation de revêtement par décharge d'arc électrique selon les revendications 7 et 8, caractérisé en ce que pour le chauffage des pièces (9) devant être revêtues, le premier interrupteur (15) est fermé, le second et le troisième interrupteur (16, 17) sont ouverts, et les masques (12) sont dans leur position extrême entravant le champ de visée.
